# EUROPÄISCHE PATENTSCHRIFT

(11) **EP 1 299 899 B1**
(45) Veröffentlichungstag und Bekanntmachung des Hinweises auf die Patenterteilung: **04.11.2009**
(21) Anmeldenummer: 01944853.9
(22) Anmeldetag: 06.07.2001
(51) Int. Cl.: H01L 21/00

(54) **SPEICHERVORRICHTUNG, INSBESONDERE ZUR ZWISCHENLAGERUNG VON TEST-WAFERN**
STORAGE DEVICE, ESPECIALLY FOR THE INTERMEDIATE STORAGE OF TEST WAFERS
DISPOSITIF DE STOCKAGE, EN PARTICULIER POUR LE STOCKAGE INTERMEDIAIRE DE TRANCHES DE SEMI-CONDUCTEUR D'ESSAI

(30) Priorität: 09.07.2000 CH 135300
(43) Veröffentlichungstag der Anmeldung: 09.04.2003
(73) Patentinhaber: Brooks-PRI Automation (Switzerland) GmbH, 8274 Tägerwilen (CH)
(72) Erfinder: BLATTNER, Jakob, CH-8272 Ermatingen (CH); RUDY, Federici, CH-8572 Berg (CH)
(74) Vertreter: Klein, Friedrich Jürgen
(86) Internationale Anmeldenummer: PCT/CH2001/000422
(87) Internationale Veröffentlichungsnummer: WO 2002/005320

(56) Entgegenhaltungen:
- EP-A- 0 827 194
- WO-A-00/03417
- WO-A-00/22653
- WO-A-99/02436

## Beschreibung

Die Erfindung betrifft eine Speichervorrichtung für eine Zwischenlagerung von für die Produktion von Halbleiterbauelementen vorgesehenen Objekten, wie Substrate, Wafer, insbesondere Testwafer, und dergleichen, wobei die Speichervorrichtung ein Gehäuse aufweist, das einen Innenraum umschliesst, in dem Innenraum in einem Be-/Entladebereich eine Einrichtung zum Ein- und Ausführen der Objekte aus bzw. in das Gehäuse vorgesehen ist, wozu am Gehäuse zumindest eine verschliessbare Öffnung vorgesehen ist, durch welche die Objekte ein- und ausführbar sind, die Objekte im Innenraum in offenen transportablen Speichermitteln angeordnet werden können, wie beispielsweise Magazinen, wobei im Innenraum für die Speichermittel Lagerplätze vorhanden sind, die Speichervorrichtung ferner eine Transfereinrichtung zur Bildung von Objektstapeln aufweist. Die Erfindung betrifft zudem ein Verfahren gemäss dem Oberbegriff von Anspruch 12,

Grundlage für die Herstellung elektronischer Bauteile sind in bestimmter Weise vorbearbeitete Substrate, wie Halbleiterscheiben, Glasplatten oder dergleichen. Halbleiterscheiben, insbesondere Siliziumscheiben, werden in diesem Zusammenhang üblicherweise als Wafer bezeichnet. Für die Produktion von elektronischen Bauelementen müssen diese Substrate zu ihrer Oberflächenbearbeitung verschiedene Prozessstufen durchlaufen. Dabei werden beispielsweise Roh-Wafer (unprozessierte Wafer) hergestellt und in der Regel zwischen dem Durchlaufen von einzelnen Prozessstufen in Transport-und Aufbewahrungsbehältern zwischengelagert. Damit die einzelnen Prozessstufen gute Arbeitsergebnisse liefern, ist es häufig erforderlich, Prozessparameter einzustellen. In vielen Fällen werden die Prozessparameter empirisch ermittelt, indem zunächst sogenannte Test-Wafer den Bearbeitungsprozess durchlaufen. Anhand deren Zustand nach einem oder mehrmaligem Durchlaufen des jeweiligen Prozesses können die einzustellenden Werte der Parameter abgeleitet werden.

Sowohl Test- als auch tatsächlich zu bearbeitende Wafer müssen für den Transport zu dem eigentlichen Bearbeitungsprozess als Waferstapel in einen Transportbehälter eingeführt werden. Die Anzahl der in einem Behälter vorgesehenen Wafern wird auch als "Batch" (Stapel) bezeichnet. Die Batch-Grösse ist genormt und beträgt üblicherweise 25 (oder 13) Wafer. Für die Bearbeitung selbst müssen die Wafer dem Transportbehälter entnommen werden, einer Vorrichtung zur Durchführung des Bearbeitungsprozesses zugeführt und anschliessend wieder in einen Behälter abgelegt werden.

Ein grundlegendes Problem bei der gesamten Verarbeitung und Zwischenlagerung besteht darin, dass die Substrate von Verunreinigungen und Schmutz ferngehalten werden müssen. Bereits kleinste Verunreinigungen durch Staub oder sonstige Partikel erzeugen eine Schädigung des entsprechenden Bereiches der Substrat-Oberfläche. Dies kann zu erheblichen Ausschussraten der aus diesen Substraten hergestellten Endprodukte führen. Deshalb erfolgt die Verarbeitung üblicherweise in sogenannter Reinraumtechnik, d.h. die Verarbeitungszonen müssen eine bestimmte, festgelegte Reinheit in Bezug auf diese Schmutzpartikel aufweisen. Dasselbe gilt auch für die Zwischenlagerung, d.h. die Aufbewahrungsbehälter.

Es sind deshalb schon Speichervorrichtungen für die Zwischenlagerung von Wafern bekannt geworden, beispielsweise aus der DE 198 47 659, in denen Wafer offen gelagert werden. In diesen Speichervorrichtungen sind auch Einrichtungen zum Be- und Entladen von Transportbehältern mit Wafern vorgesehen. Ausserdem ist üblicherweise ein frei bewegbarer Roboterarm vorhanden, mit dem einzelne Wafer gegriffen und von ihren horizontal ausgerichteten Speichermitteln zur Be- und Entladeeinrichtung gebracht werden können. Bei diesen vorbekannten Speichervorrichtungen ist jedoch nicht zufriedenstellend, dass die Zusammenstellung von einzelnen Waferstapel relativ viel Zeit in Anspruch nimmt. Des Weiteren benötigen diese Speichervorrichtungen in Bezug auf ihre Speicherkapazität relativ viel Platz. Ausserdem ist es nur mit sehr viel Aufwand möglich, die Speichermittel zu reinigen, was jedoch regelmässig erfolgen sollte.

Ferner wird in der internationalen Patentanmeldung WO 00/22653 eine Lager-/Sortieranlage für Wafer beschrieben, die sowohl in Kassetten angeordnete Wafer in einem Teil der Anlage zwischenlagern, als auch Waferstapel zusammenstellen kann. Das beschriebene Verfahren zur Erstellung eines Substratstapels entspricht dem Oberbegriff des Anpruchs 12 der vorliegenden Anmeldung. Die Wafer sind hierzu in der Lager-/Sortieranlage in als FOUPs ((Front Open Unified Pod)ausgebildeten Standard-Transportboxen angeordnet. Die FOUPs werden an einer Schleuse geöffnet und anschliessend komplett in eine erste Kammer des Gehäuses der Anlage eingeführt. Hier kann die komplette Transportbox entweder in einem Stocker zwischengelagert oder zu einer verschliessbaren Schnittstelle gebracht werden. Die verschliessbare Schnittstelle trennt die erste Kammer von einer zweiten Kammer des Gehäuses ab, wobei in der zweiten Kammer verschiedene Mess- und Leseeinrichtungen sowie ein Roboter angeordnet sind, mit dem Waferstapel zusammengestellt werden können. Die aus der Anlage hinaus zuführenden Waferstapel werden dadurch erzeugt, dass stets einzelne Wafer mittels dem Roboter direkt in ein FOUP eingesetzt werden. Der FOUP kann dann anschliessend aus der Anlage ausgeführt oder im Stocker zwischengelagert werden. Auch diese vorbekannte Anlage kann hinsichtlich des Platzbedarfs der Anlage und des erforderlichen Aufwands zur Erzielung guter Reinraumqualität nicht zufrieden stellen.

Der Erfindung liegt deshalb die Aufgabe zugrunde, eine Speichervorrichtung für die genannten Objekte zu bilden, in der es zusätzlich möglich ist, auf effiziente Weise und unter Berücksichtung von hohen Reinraumanforderungen einen Stapel oder ein Batch der Objekte zusammenzustellen.

Diese Aufgabe wird durch eine Speichervorrichtung gemäß Patentanspruch 1 sowie durch ein Verfahren gemäß Patentanspruch 12. gelöst. Hierbei ist vorgesehen dass an der zumindest einen Öffnung des Gehäuses eine Transportbox für Objekte mit ihrer Öffnungsseite angeordnet werden kann, mittels der ersten Handhabungseinrichtung, ein oder mehrere Objekte direkt erfasst und von der Transportbox in den Innenraum einführbar sind, die Objekte in einem der mehreren, bereits innerhalb des Innenraums angeordneten Speichermittel einsetzbar sind, die Speichermittel mittels einer zweiten Handhabungseinrichtung in Lagerplätzen des Innenraums anordenbar sind, und die Transfereinrichtung ebenfalls innerhalb des Innenraums vorgesehen ist, mit der zur Zusammenstellung eines Objektstapels aus zumindest einem Speichermittel ein oder mehrere Objekte entnehmbar und in einer im Innenraum angeordneten Aufnahme einsetzbar sind.

Erfindungsgemäss ist somit vorgesehen, dass die Transportboxen nicht in die mehrfunktionale Speichervorrichtung eingeführt werden. Da die Gefahr besteht, dass die Transportboxen auf ihren Aussenflächen mit Partikeln verschmutzt sind, kann hierdurch in der Speichervorrichtung selbst der Aufwand zur Aufrechterhaltung bestimmter Reinraumqualitäten vergleichsweise gering gehalten werden. Trotz dieses geringen Aufwandes kann die Gefahr von Verschmutzungen der Objekte gering gehalten werden.

Um die aus einer Transportbox entnommenen Wafer bzw. Substrate in der Speichervorrichtung vorzugsweise batchweise zwischenlagern zu können, sind Speichermittel vorgesehen. Diese Speichermittel, vorzugsweise offene Magazine, sind zwar zum Transport der Wafer innerhalb der Speichervorrichtung selbst transportabel, sollten aber üblicherweise in der Speichervorrichtung verbleiben, auch wenn die bisher darin angeordneten Wafer aus der Speichervorrichtung ausgeführt werden. Hierdurch wird die Gefahr einer Kontamination der Wafer weiter verringert.

Im Vergleich zu einer einzelnen Handhabung jedes Wafers können durch den gleichzeitigen Transport mehrerer Wafer in einem Speichermittel die zur Bildung eines Waferstapels benötigten Wafer schneller zur Be- und Entladeeinrichtung gebracht werden. Zudem muss mit dem Greifer lediglich ein Speichermittel transportiert und gehandhabt werden. Da die Wafer während des Transports zur Transfereinrichtung bzw. zum Be-/Entladebereich in den Speichermitteln verbleiben können, wird auch die Gefahr einer Beschädigung der Wafer, beispielsweise durch ein Umladen, erheblich verringert.

Des Weiteren ist es nun weit einfacher, die Speichermittel zu reinigen, da sie beispielsweise einzeln der Speichervorrichtung entnommen und ausserhalb von dieser gereinigt werden können. Hierzu ist es nicht mehr erforderlich, die gesamte Speichervorrichtung ausser Betrieb zu setzen.

Ein weiterer Vorteil der erfindungsgemässen Speichervorrichtung besteht darin, dass die Handhabungseinrichtung zur Handhabung der Objekte konstruktiv weit einfacher ausgestaltet sein kann, als der in der DE 198 47 659 offenbarte Roboter. Bei der erfindungsgemässen Speichervorrichtung müssen von ihrer Handhabungseinrichtung nämlich nur einzelne Speichermittel gegriffen und transportiert werden. Im Hinblick auf mögliche Beschädigungen der Wafer ist dies weit weniger kritisch als die unmittelbare Handhabung der Wafer durch einen Roboter. Ausserdem muss von der Handhabungseinrichtung nur eine relativ geringe Anzahl an Lagerplätzen angefahren werden. Gegenüber der genannten vorbekannten Speichervorrichtung, bei welcher der Roboter jedes einzelne Fach anfahren muss, bedingt dies einen geringeren konstruktiven Aufwand.

Die zum Transport der Speichermittel vorgesehene Handhabungseinrichtung kann insbesondere in Abhängigkeit von der konstruktiven Ausgestaltung der Speichermittel in vielfältiger Weise ausgebildet sein. Es muss lediglich sichergestellt sein, dass die Speichermittel sicher gegriffen werden. Es ist jedoch bevorzugt, wenn die Handhabungseinrichtung einen passiven Greifer aufweist. Ein solcher Greifer erfasst beispielsweise während einer Bewegung eines Armes der Handhabungsvorrichtung ein Speichermittel und nimmt dieses mit. Eine gesonderte Bewegung des Greifers selbst ist, anders als beispielsweise bei einem Zweibackengreifer, dessen Backen eine Zustellungbewegung ausführen, nicht erforderlich.

Die Speichermittel können vorzugsweise in Form von offenen Kassetten ausgebildet sein, wie sie in ähnlicher Weise auch in Transportbehältern für Wafer vorgesehen sind. Diese Speichermittel weisen parallel nebeneinander angeordnete Schlitze auf, in die die Wafer eingesetzt werden. Die Schlitze verlaufen vorzugsweise vertikal, so dass auch die Wafer mit ihren beiden Scheibenflächen im wesentlichen vertikal ausgerichtet sind. Das Speichermittel ist ferner mit einer Standfläche versehen, mit der es auf einem nach Möglichkeit im wesentlichen horizontal verlaufender Abstellfläche, beispielsweise der Lagerplätze, abgestellt werden kann.

In einer bevorzugten Ausführungsform der Erfindung weist die Be- und Entladeeinrichtung einen Einzelwafergreifer auf, mit dem sich aus einem Speichermittel Wafer einzeln herausnehmen bzw. einsetzen lassen. Durch Verwendung dieses Greifers können logische Einheiten von Wafern vollautomatisch aus zwischengelagerten Wafern zusammengestellt werden. So ist es beispielsweise möglich, einen Stapel von Testwafern zusammenzustellen, in ein Speichermittel einzusetzen und dieses Speichermittel an einem der Lagerplätze der Speichervorrichtung ebenfalls vollautomatisch so lange zu lagern, bis der Stapel in der Produktion benötigt wird. Die Zusammenstellung der Waferstapel kann vorzugsweise zu Zeiten erfolgen, während denen die Be- und Entladeeinrichtung keine anderen Aufgaben auszuführen hat.

Die Zusammenstellung eines Waferstapels kann aber auch aus einem Speichermittel erfolgen, das von einem Lagerplatz aus zur Be- und Entladeeinrichtung gebracht wurde. Da die einzelnen Speichermittel vorzugsweise mehr Wafer aufnehmen können als Wafer in einem ein- oder auszuführenden Waferstapel vorhanden sind, kann der Waferstapel aus den Wafern nur eines Speichermittels zusammengestellt werden. Es ist aber auch möglich, hierfür mehrere Speichermittel heranzuziehen.

Die erfindungsgemässe Speichervorrichtung eignet sich in besonderem Masse für eine Zwischenlagerung und Stapelerzeugung von Test-Wafern. In ihr können aber selbstverständlich auch Wafer gelagert werden, die tatsächlich zur Produktion von Halbleiterbauelementen vorgesehen sind. Ebenso können auch andere Substrate und auch Produktionsmittel aus der Halbleiterelementeproduktion zwischengelagert werden.

Weitere bevorzugte Ausgestaltungen der Erfindung ergeben sich aus den Ansprüchen.

Die Erfindung wird anhand den in den Figuren rein schematisch dargestellten Ausführungsbeispielen näher erläutert; es zeigen:
- Fig. 1: eine erfindungsgemässe Speichervorrichtung in einer perspektivischen Darstellung, bei der eine an sich vollständig geschlossene Front- seite teilweise geöffnet dargestellt ist;
- Fig. 2: eine Draufsicht auf eine erfindungsgemässe Speichervorrichtung;
- Fig. 3: ein Teil eines Be-/Entladebereichs der Speichervorrichtung aus Fig.1;
- Fig. 4: eine Frontansicht auf Greifmittel eines Transfergreifers;
- Fig. 5: ein Ladeplatz und eine Detektionseinrichtung der Speichervorrichtung in einer Frontansicht;
- Fig. 6: ein über einem Lagerplatz angeordnetes Speichermittel sowie ein Greiferelement in einer perspektivischen Darstellung;
- Fig. 7: eine Frontansicht auf einen Speicherbereich der Speichervorrichtung aus Fig. 1.

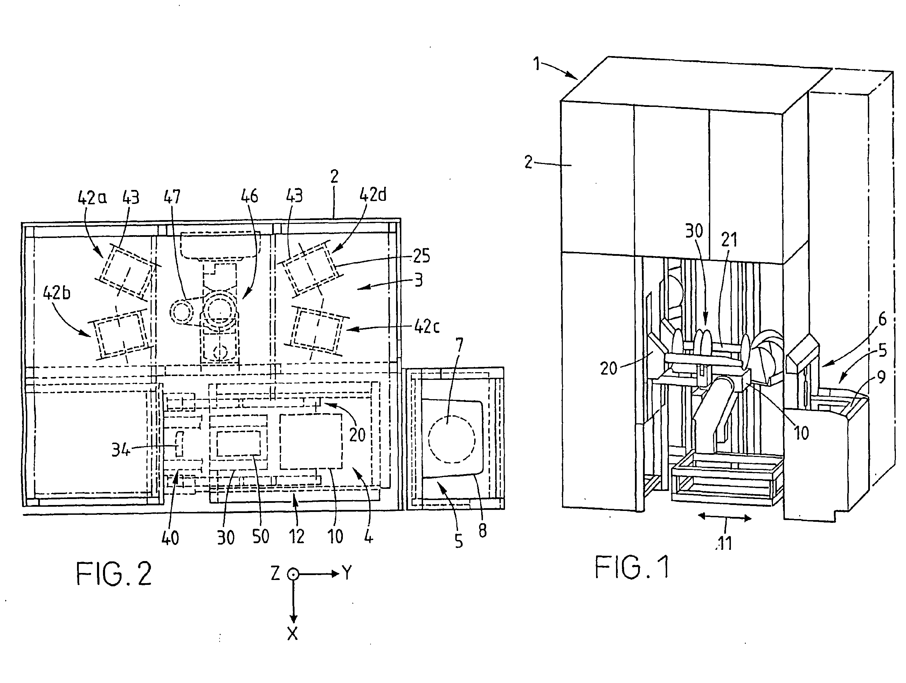

Die Figuren 1 und 2 zeigen eine erfindungsgemässe Speichervorrichtung 1, deren verschliessbares Gehäuse 2 einen einzigen zusammenhängenden Innenraum ausbildet. Im Innenraum ist ein Speicherbereich 3, ein Be-/Entladebereich 4 und ein Transferbereich 12 vorgesehen. In den Bereichen werden unabhängig voneinander abwärtsgerichtete Luftströme erzeugt, durch die im gesamten Gehäuse Reinraumbedingungen sichergestellt werden.

Eine Ein-/Ausgabestation 5 befindet sich im Bereich einer verschliessbaren Öffnung 6 des Gehäuses 2. Mittels der Ein-/Ausgabestation 5 kann ein nur in Fig. 2 gezeigter Waferstapel 7 aus einer Transportbox 8 entnommen und in die Speichervorrichtung 1 eingeführt werden. Ebenso kann unter Zuhilfenahme der Ein-/Ausgabestation 5 von der Speichervorrichtung 1 aus ein Waferstapel in die Transportbox 7 eingesetzt werden. Auf einer ausserhalb des Innenraums angeordneten Stellfläche 9 der Ein-/Ausgabestation 5 kann hierzu eine Transportbox 8 mit ihrer Öffnungsseite zur verschliessbaren Öffnung 6 weisend abgestellt und geöffnet werden. Derartige Transportboxen sind beispielsweise als FOUP- (Front Open Unified Pod) oder SMIF-Boxen (Standard Mechanical Interface) seit langem bekannt und genormt. Mechanismen zum gleichzeitigen Öffnen bzw. Verschliessen einer Transportbox und einer Verschlussplatte einer Öffnung des Gehäuses sind dem Fachmann deshalb ebenfalls geläufig.

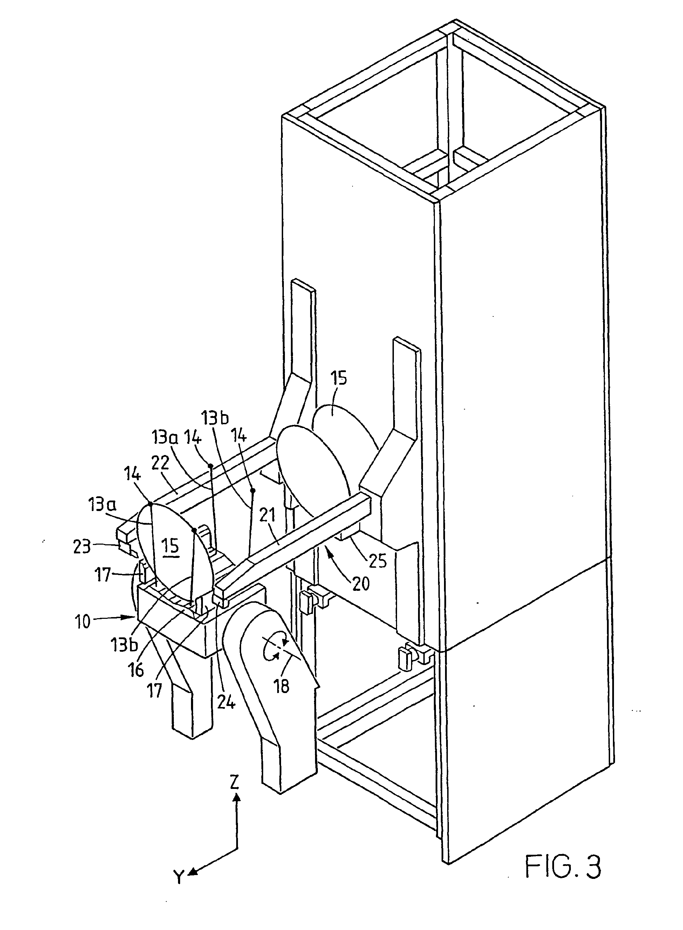

In dem sich gegenüber der Öffnung 6 des Gehäuses 2 befindenden Be-/Entladebereich ist ein Stapelgreifer 10 (sogenannter Batch-Greifer) zum gleichzeitigen Greifen mehrerer Wafer, vorzugsweise des gesamten Inhalts eines Transportbehälters, angeordnet. Die als Stapelgreifer 10 ausgebildete erste Handhabungseinrichtung ist entlang einer translatorischen Achse (Doppelpfeil 11) verfahrbar und weist für je zwei Wafer eines Stapels einen Greifer auf. Wie insbesondere in Fig. 3 gezeigt ist, hat jeder Greifer zwei an drehbaren Stangen befestigte Greifköpfe 14. Aus Gründen der Deutlichkeit sind in Fig. 3 nur die beiden äusseren Greifer des Stapelgreifers 10 dargestellt. Zwischen diesen beiden gezeigten Greifern befindet sich eine Anzahl an entsprechenden weiteren Greifern, so dass für je zwei Wafer 15 eines Waferstapels ein Greifer vorhanden ist.

Ausserdem weist der Stapelgreifer 10 einen längsverschiebbaren Gegenhalter 16 und ein Aufnahmemittel auf, das zwei Leisten 17 hat, die mit Schlitzen versehen sind. Die Wafer können somit zwischen dem Gegenhalter 16 und den Greifköpfen 14 gehalten werden, wobei hierbei der Greifer die Wafer lediglich an seinen Seitenkanten berührt. Ausserdem können die Wafer in den beiden Leisten 17 abgesetzt werden. Die Greifer sind miteinander verbunden und führen stets gemeinsam die gleichen Bewegungen aus. Zur Entnahme der in einer FOUP-Box im wesentlichen horizontal angeordneten Wafer ist der Stapelgreifer 10 mit seinen Stangen 13a, 13b im wesentlichen horizontal ausgerichtet. Für die nachfolgende Handhabung der Wafer wird der Stapelgreifer 10 um ca. 90° um eine Achse 18 geschwenkt, so dass die Wafer mit ihren Oberflächen vertikal ausgerichtet sind. Diese Situation ist in Fig. 3 gezeigt. Ein solcher Stapelgreifer 10 ist beispielsweise aus der WO 98/15971 der gleichen Anmelderin bekannt.

In dem sich unmittelbar an den Be-/Entladebereich 4 anschliessenden Transferbereich 12 ist eine als Transfergreifer 20 ausgebildete weitere Handhabungseinrichtung vorgesehen, mit der aus dem Stapelgreifer Wafer entnommen werden können. Der zuvor beschriebene Stapelgreifer 10 verweilt hierzu an einer vorgegebenen Übergabestelle in der Ausrichtung, in welcher die Wafer im Aufnahmemittel angeordnet und im wesentlichen vertikal orientiert sind. Zur Entnahme der Wafer durch den Transfergreifer 20 geben ausserdem die Greifköpfe 14 des Stapelgreifers die Wafer frei, so dass sie in einer Richtung im wesentlichen vertikal nach oben aus dem Stapelgreifer entnommen werden können.

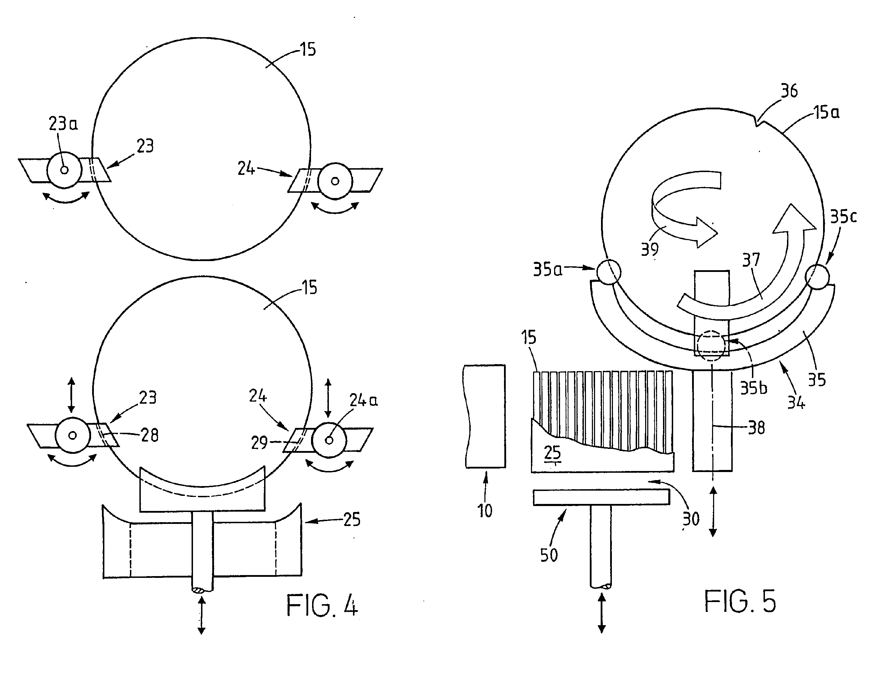

Ein solcher Transfergreifer 20 kann beispielsweise wie der in der WO 00/03417 der gleichen Anmelderin gezeigte Greifer ausgebildet sein. greifer 20 weist zwei simultan bewegbare und voneinander beabstandete Arme 21, 22 auf, an deren freien Enden Greifmittel 23, 24 vorgesehen sind. Mit den einen Enden der geschlitzten Greifmitteln 23, 24 der beiden Arme lässt sich jeweils gemeinsam nur ein Wafer erfassen und handhaben. Der Abstand der beiden Greifmittel ist dabei kleiner als der Durchmesser eines Wafers, so dass durch eine Bewegung von unten nach oben ein Wafer von den passiven Greifmitteln erfasst und aus dem Stapelgreifer 10 entnommen werden kann (Fig. 4). Durch eine Bewegung in umgekehrter Richtung lässt sich ein Wafer im Stapelgreifer 10 oder in einem Speichermittel 25 absetzen.

Wie in Fig. 4 gezeigt ist, können die Greifmittel 23, 24 um jeweils eine gegenüber der Zeichenebene orthogonal ausgerichtete Achse 23a, 24a schwenkbar ausgebildet sein. Hierdurch ist es möglich, den Transfergreifer 20 sowohl als Einzelwafer-Greifer als auch als Mehrfachgreifer auszubilden. Durch eine Drehung um 180° liegen sich nämlich zweite Greifmittel 26, 27 gegenüber, an denen jeweils hintereinander mehrere geschlitzte Aufnahmen zur gleichzeitigen Handhabung mehrerer Wafer ausgebildet sind. Die einzelnen Aufnahmen können im wesentlichen gleich gestaltet sein wie sie auch bei den Greifmitteln 23, 24 des Einzelwafergreifer vorgesehen sind. Durch eine entsprechende Wahl eines Abstandes aufeinanderfolgender Aufnahmen für Wafer an den Greifmitteln 26, 27 des Mehrfachgreifers können entweder unmittelbar nebeneinander stehende Wafer 15 erfasst oder beispielsweise nur jeder zweite, dritte etc. Wafer des Stapels entnommen werden.

Die Aufnahmen des Mehrfach- bzw. Einzelwafergreifer weisen hierzu auf jeder Seite eines Waferstapels eine Kontaktstelle 28, 29 auf, deren Abstand zueinander kleiner als ein Waferdurchmesser ist. Ohne einen Wafer zu greifen, befinden sich die Kontaktstellen 28, 29 stets unterhalb der Wafer 15. Ausser einer dadurch möglichen geradlinigen Bewegung entlang eines Speichermittels (senkrecht zur Zeichenebene von Fig. 4) kann der Einzelwafer-Greifer auch parallel zu den beiden Oberflächen der Wafer verfahren werden. Hierdurch kann der Einzelwafer-Greifer von einer Verfahrposition in eine Transportposition überführt werden. Ein Wafer kann hierbei vom Greifer erfasst und angehoben werden. Dadurch ist der jeweilige Wafer im Greifer in einer Zweipunktlage fixiert und wird, ohne Relativbewegungen gegenüber dem Greifer auszuführen, von letzterem in die Transportposition mitgenommen, in welcher sich der Wafer vollständig ausserhalb des Ausgangsstapels befindet. Von hier aus kann der Wafer durch den Transfergreifer zum Aufnahmemittel gebracht und dort eingesetzt werden. Auf diese Weise können aus dem Ausgangsstapel die benötigten Wafer entnommen und in den Leisten 17 des Aufnahmemittels zu einem neuen Waferstapel zusammengesetzt werden.

Der Transfergreifer kann mit einem nicht dargestellten Sensormittel, beispielsweise einem optischen Lichtschrankensensor, versehen sein, mit dem festgestellt werden kann, ob sich zwischen den beiden Kontaktstellen ein Wafer befindet, der gegriffen werden kann bzw. bereits gegriffen ist. Des Weiteren kann vorgesehen sein, mit geeigneten Detektionsmitteln festzustellen, ob Wafer in den Speichermitteln bzw. Aufnahmemittel korrekt eingesetzt sind.

Alternativ zu den beschriebenen Einzelwafer-Greifer kann auch ein Mehrfachgreifer benutzt werden, der sich beispielsweise aus mehreren der zuvor beschriebenen Einzelwafer-Greifern zusammensetzt, wie dies in der älteren Anmeldung EP 1 208 584 A1 der gleichen Anmelderin ebenfalls beschrieben ist. Bei einem solchen Mehrfachgreifer sind die einzelnen Greifer einzeln betätigbar, entlang eines Waferstapels jedoch nur gemeinsam verfahrbar. Mit diesem Mehrfachgreifer können beliebige Wafer einem Ausgangsstapel entnommen und gemeinsam zum Aufnahmemittel gebracht und dort abgesetzt werden.

Gleich in welcher Form der Transfergreifer ausgebildet ist, kann er jeweils die von ihm entnommenen Wafer in einer ebenfalls vertikalen Ausrichtung in ein in Fig. 3 nur teilweise dargestelltes Speichermittel 25 einsetzen, beispielsweise ein Magazin oder eine Kassette, das hinter dem Stapelgreifer 10 angeordnet ist. Das Speichermittel 25 ist hierzu an einem Ladeplatz 30 angeordnet (Fig. 1 und 2).

Am Ladeplatz kann ein Ausstosser 50 (Fig. 5) vorgesehen sein, der durch ein Speichermittel 25 hindurchführbar ist und hierbei sämtliche Wafer im Speichermittel nach oben anhebt. Der Ausstosser kann ein entsprechend dem nachfolgend noch näher erläuterten Speichermittel 25 gestaltetes Bauteil sein, dessen Breite kleiner ist als als eine Öffnung im Speichermittel 25. Ausserdem ist der Aussstosser in vertikaler Richtung verfahrbar. Der Ausstosser 50 ist ebenfalls mit Schlitzen zur Aufnahme von Wafern versehen, wobei dessen Schlitze den gleichen Abstand aufweisen wie jene der Speichermittel 25. Dadurch kann durch eine vertikale Bewegung des Ausstossers nach oben, der Ausstosser 50 durch ein Speichermittel 25 hindurchgeführt und ein Waferstapel vom Speichermittel an den Ausstosser übergeben werden. Durch eine entsprechende Bewegung nach unten kann ein Stapel auch in ein Speichermittel eingesetzt werden.

Ebenfalls in einer Linie mit dem Stapelgreifer 10 und dem Ladeplatz 30 kann hinter dem Speichermittel gegebenenfalls eine nur in Fig. 2 schematisch gezeigte Detektionsstation 40 angeordnet sein, in die der Transfergreifer 20 ebenfalls Wafer einsetzen kann. Eine Reichweite des lediglich entlang zweier translatorischer Achsen Y und Z bewegbaren Transfergreifers 20 reicht somit von der Detektionsstation 40 bis zum Stapelgreifer 10.

Wie Fig. 5 entnommen werden kann, weist die Detektionsstation 40 einen vertikal verfahrbaren Schieber 34 auf, der hierbei mit einem Schieberarm 35 einen einzelnen oder gleichzeitig mehrere Wafer 15a nach oben anheben kann. Der Wafer 15a liegt hierbei an drei oder mehr Kontaktstellen 35a, 35b, 35c (beispielsweise geschlitzte Rollen) des Schieberarms 35 auf. Der Schieberarm weist an sich vorbekannte Detektionsmittel zur Auffindung einer Kerbe 36 des Wafers auf. Mittels dieser seit langem üblichen Kerbe können Wafer in vorbestimmter Weise rotatorisch ausgerichtet werden. Ferner können die Kontaktstellen 35a-c gegenüber dem Schieberarm 35 drehbar ausgestaltet sein, wodurch der jeweilige Wafer 15a mit seiner Kerbe an einer bestimmten Stelle angeordnet werden kann (Pfeil 37). Zusätzlich können weitere geeignete (jedoch nicht dargestellte) Detektionsmittel vorgesehen sein, mit denen auch ein Identifikationsmittel des jeweiligen Wafers, beispielsweise ein Barcode des Wafers, detektiert wird. Schliesslich kann auch vorgesehen sein , dass der Schieberarm um eine vertikale Achse 38, die mit einer Durchmesserlinie eines im Schieberarm 35 angeordneten Wafers zusammenfällt, drehbar ist (Pfeil 39). Dadurch kann ein Wafer um 180° gedreht werden (sogenanntes Wafer Flipping). Eine solche Änderung seiner Ausrichtung in einem Waferstapel hat für einige Bearbeitungsprozesse Vorteile.

Im Be-/Entladebereich ist es auch möglich, sogenannte verdichtete Waferstapel zu bilden. Unter Verdichtung ist in diesem Zusammenhang zu verstehen, dass nebeneinander angeordnete Wafer einen geringeren Abstand zueinander aufweisen als der genormte Abstand, den die Wafer während ihres Transports in Transport-Boxen haben. Unter Verdichtung kann aber auch allgemein verstanden werden, dass Wafer in einem neuen Stapel angeordnet werden, in dem aufeinanderfolgende Wafer einen geringeren Abstand zueinander aufweisen als im Ausgangsstapel. Es ist daher in einem verdichteten Stapel möglich, bei einer gleichen Länge bzw. Höhe des Stapels mehr Wafer vorzusehen. Bei einem Verdichtungsverhältnis von beispielsweise zwei, drei oder vier weisen die Wafer zueinander noch die Hälfte, ein Drittel bzw, ein Viertel des ursprünglichen Abstandes zueinander auf.

Eine Verdichtung kann mit der im Ausführungsbeispiel gezeigten Speichervorrichtung 1 am einfachsten dadurch erzielt werden, dass der Transfergreifer 20 die Wafer 15 in einem Speichermittel 25 anordnet, deren jeweils aufeinanderfolgenden Aufnahmen einen gegenüber den Greifern des Stapelgreifers 10 geringeren Abstand zueinander aufweisen. Dadurch können beispielsweise Wafer von zwei, drei oder vier Ausgangsstapeln auf einer Länge eines Ausgangsstapels angeordnet werden.

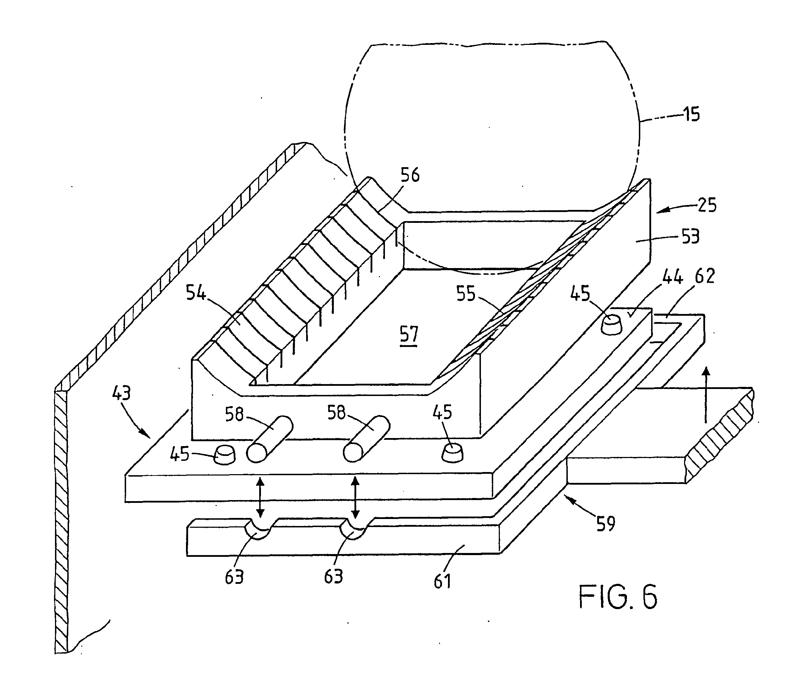

Wie in Fig. 2 gezeigt ist, sind im Speicherbereich 3 der Speichervorrichtung in vier Spalten 42a-d Lagerplätze 43 (Fig. 6) übereinander in Form von regalartigen Elementen vorgesehen, auf deren horizontal ausgerichteten Abstellflächen 44 jeweils eines der Speichermittel 25 abgestellt werden kann. Jedes regalartige Element kann Positionierhilfsmittel aufweisen, mit denen sich die Speichermittel 25 bei grober Vorpositionierung von selbst ausrichten. Hierzu kann beispielsweise vorgesehen sein, dass die regalartigen Elemente mehrere kegelstumpfförmige Positionerelemente 45 aufweisen, auf welche die Speichermittel 25 aufgesetzt werden. Da die Speichermittel an ihrer Unterseite mit entsprechenden Ausnehmungen gestaltet sein können, gleiten sie beim Absetzen auf dem jeweiligen Lagerplatz 43 an den Positionierelementen entlang in eine vorbestimmte Position.

Zwischen den beiden paarweise angeordneten Spalten 42a, 42b; 42c, 42d ist noch eine weitere Handhabungseinrichtung in Form eines nur teilweise dargestellten Knickarmroboters 46 vorgesehen (Fig. 2). Der in Z-Richtung (senkrecht zur Zeichenebene von Fig. 2) verfahrbare Knickarmroboter, dessen Knickarm 47 sich in X-Y-Ebenen horizontal bewegen lässt, ist dabei so angeordnet, dass er zu jeder der auf ihn ausgerichteten Spalten der Lagerplätze 43 zumindest in etwa den gleichen Abstand aufweist. Der Knickarmroboter 46 ist jeweils in Höhe der regalartigen Elemente positionierbar. Eine Armlänge des Knickarmroboters ist schliesslich so gewählt, dass der Knickarmroboter auch Zugriff auf den Ladeplatz 30 hat. Hierdurch ist es möglich, mit dem Knickarmroboter Speichermittel vom Ladeplatz zu entnehmen bzw. solche am Ladeplatz abzusetzen.

In Fig. 6 ist eine von beliebig vielen möglichen Ausgestaltungen eines Speichermittels 25 näher gezeigt. Wie in dieser Darstellung zu erkennen ist, weist dieses Speichermittel zwei parallel zueinander ausgerichtete Stege 53, 54 auf, in denen jeweils Schlitze 55, 56 zur im wesentlichen vertikalen Aufnahme von Wafern 15 ausgebildet sind. In Fig. 6 ist aus Gründen der Deutlichkeit mit Strichlinien lediglich ein Wafer 15 teilweise dargestellt. Die beiden Stege 53, 54 sind an an den Stirnseiten des Speichermittels miteinander verbunden. Zwischen den Stegen ist eine Öffnung 57 vorgesehen, durch die der Ausstosser 50 (vgl. Fig. 2 und 5) hindurchführbar ist. Ausserdem können an nahezu beliebigen Stellen des Speichermittels Mitnahmemittel vorgesehen sein, durch die sich das Speichermittel von einem vorzugsweise passiven Greiferelement zum Transport erfassen lässt. Im Ausführungsbeispiel sind die Mitnahmeelemente an Stirnseiten des Speichermittels 25 vorgesehen. Sie sind hier in Form von jeweils zwei Zapfen 58 ausgebildet, die jeweils über die Abstellfläche überstehen können. In anderen Ausführungsbeispielen könnten die Mitnahmemittel beispielsweise auch als Ausnehmungen an der Unterseite des Speichermittels ausgebildet sein, in die das Greiferelement des Knickarmroboters durch eine Bewegung parallel zur Abstellfläche 44 gelangt.

Das Greifelement der Handhabungseinrichtung sollte so gestaltet, dass es mit den Mitnahmemitteln des Speichermittels zusammenwirkt. Das in Fig. 6 gezeigte Greiferelement 59 des Knickarmroboters 46 kann deswegen gabelförmig ausgebildet sein. Da ein Abstand der beiden Gabelelementen 61, 62 grösser ist als eine Länge der Abstellfläche 44 können die beiden Gabelelemente an den Stirnseiten der Lagerplätze vertikal nach oben vorbeigeführt werden. Hierbei gelangen die Zapfen 58 in entsprechende Ausnehmungen 63 der Gabelelemente. Durch die dabei entstehende formschlüssige Anordnung erfasst der Knickarmroboter das jeweilige Speichermittel 25 und kann es im Folgenden eine eine vorgegebene Stelle, beispielsweise an den Ladeplatz 30, transportieren.

Um mit dieser erfindungsgemässen Speichervorrichtung einen neuen Waferstapel zusammenzustellen und auszugeben, wird zunächst mit dem Knickarmroboter 46 ein Speichermittel auf seinem Lagerplatz 43 erfasst, zum Ladeplatz 30 gebracht und dort abgesetzt. Am Ladeplatz werden die Wafer mittels des Ausstossers 50 aus dem Speichermittel 25 angehoben, so dass sie für den Transfergreifer 20 zugänglich sind. Der Transfergreifer 20 entnimmt aus dem Speichermittel jene Wafer, die zu einem neuen Waferstapel zusammengestellt und ausgegeben werden sollen. Bevor der Transfergreifer den jeweiligen Wafer im Batchgreifer absetzt, kann er ihn auch zunächst zur Detektionsstation überführen, wo gegebenenfalls die Kerbe in vorbestimmter Weise ausgerichtet wird und die Front- und Rückseite des Wafers durch eine 180°-Drehung vertauscht werden.

Es kann eventuell auch erforderlich sein, einen neuen Waferstapel aus Wafern von zwei oder mehr Speichermittel zusammenzustellen. In diesem Fall bringt der Knickarmroboter zunächst das erste Speichermittel an den Ladeplatz 30, an dem aus dem Speichermittel eine vorbestimmte Anzahl an Wafern entnommen wird. Die Wafer werden von dem Transfergreifer 20 entweder sofort in einer vertikalen Position in den Stapelgreifer eingesetzt oder zuerst zur Detektionsstation und danach zum Stapelgreifer gebracht. Nachdem der Knickarmroboter das erste Speichermittel wieder auf einem Lagerplatz abgesetzt hat, bringt er ein zweites Speichermittel zum Ladeplatz und entnimmt auch diesem die darin für den neuen Stapel enthaltenen Wafer. Dies kann mit weiteren Speichermitteln solange wiederholt werden, bis der neue Stapel vollständig ist. Anschliessend schwenkt der Stapelgreifer die Wafer in eine horizontale Position und setzt den Stapel in eine an das Gehäuse angedockte FOUP-Box ein.

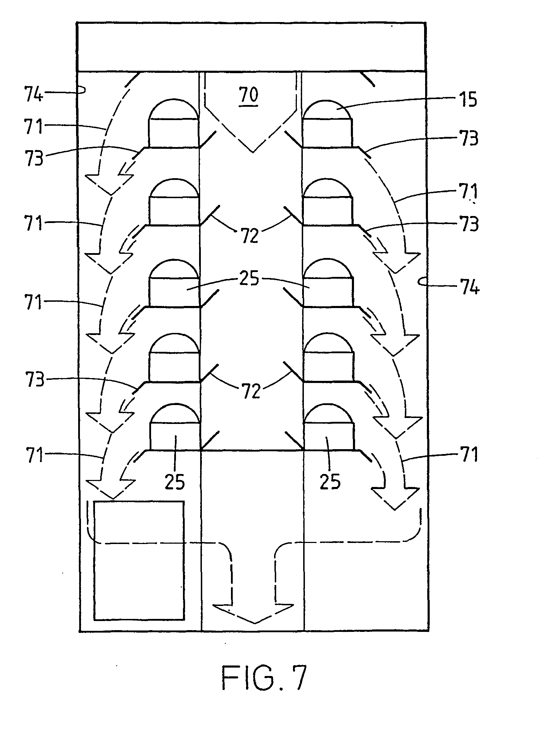

Wie in Fig. 7 schematisch angedeutet ist, kann ein im Bereich der Decke des Gehäuses in den Innenraum eintretender Luftstrom 70 des Speicherbereichs 3 in mehrere unabhängige Teilluftströme 71 aufgeteilt sein. Dies kann im wesentlichen durch die Verwendung von Strömungsleitmitteln, beispielsweise Leitblechen 72, 73 im Bereich der Lagerplätze erreicht werden. Der von oben zwischen zwei Spalten von Lagerplätzen 43 eingeleiteter zentraler Reinluftstrom wird dabei durch von nach schräg unten, in Richtung von Seitenwänden 74 des Gehäuses 2 geneigten Leitblechen in zwei separate Luftströme aufgeteilt. Die Luft tritt somit im Bodenbereich des Gehäuses 2 in Nähe der Seitenwände 74 aus dem Gehäuse aus, beispielsweise durch eine geschlitzte Bodenfläche. Zudem ist hierdurch sichergestellt, dass ein Luftstrom, der bereits an Wafern vorbeigeführt worden ist und eventuell Schmutzpartikel oder andere Verunreinigungen enthält, nicht in Kontakt mit Wafern eines anderen Speichermittels kommt. Damit kann eine sogenannte Cross-contamination vermieden werden.

## Patentansprüche

1. Speichervorrichtung für eine Zwischenlagerung von für die Produktion von Halbleiterbauelementen vorgesehenen Objekten, wie Substrate, Wafer (15, 15a), insbesondere Testwafer, und dergleichen, wobei die Speichervorrichtung
ein Gehäuse (2) aufweist, das einen Innenraum umschliesst, in dem Innenraum in einem Be-/Entladebereich eine Einrichtung zum Ein- und Ausführen der Objekte aus bzw. in das Gehäuse vorgesehen ist, wozu
am Gehäuse (2) zumindest eine verschliessbare Öffnung (6) vorgesehen ist, durch welche die Objekte ein- und ausführbar sind, wobei an der zumindest einen Öffnung (6) eine Transportbox für Objekte mit ihrer Öffnungsseite angeordnet werden kann,
ferner eine erste Handhabungseinrichtung (10) vorgesehen ist, mittels der Objekte im Be-/Entladebereich aus der Transportbox entnommen werden können, wobei
mittels der ersten Handhabungseinrichtung (10), ein oder mehrere Objekte direkt erfasst und in den Innenraum einführbar sind,
die Objekte in einem von mehreren, bereits innerhalb des Innenraums angeordneten offenen transportablen Speichermitteln (25), wie beispielweise Magazinen, einsetzbar sind,
wobei im Innenraum für die Speichermittel Lagerplätze (43) vorhanden sind,
die Speichermittel (25) mittels einer zweiten Handhabungseinrichtung (46) in Lagerplätzen (43) des Innenraums anordenbar sind,
und die Speichervorrichtung ferner
eine im Innenraum vorgesehene Transfereinrichtung (20) zur Bildung von Objektstapeln aufweist, mit der zur Zusammenstellung eines Objektstapels aus zumindest einem Speichermittel (25) ein oder mehrere Objekte entnehmbar und in einer im Innenraum angeordneten Aufnahme einsetzbar sind.

2. Speichervorrichtung nach Anspruch 1, **dadurch gekennzeichnet, dass** einzelne Speichermittel (25) jeweils mehrere Speicherstellen für jeweils ein Objekt aufweist.

3. Speichervorrichtung nach einem oder beiden der vorhergehenden Ansprüche, **dadurch gekennzeichnet, dass** die Speichermittel (25) Speicherstellen für Wafer (15, 15a) aufweisen, in denen die Wafer (15, 15a) an den Lagerplätzen in einer im wesentlichen vertikalen Ausrichtung angeordnet werden können.

4. Speichervorrichtung nach einem oder mehreren der vorhergehenden Ansprüche, **dadurch gekennzeichnet, dass** Speichermittel (25) in Form von Kassetten ausgebildet sind, in denen Schlitze Speicherstellen für Wafer (15, 15a) ausbilden.

5. Speichervorrichtung nach einem oder mehreren der vorhergehenden Ansprüche, **dadurch gekennzeichnet, dass** die Speichermittel (25) Elemente aufweisen, mit denen sie sich bei einer Verfahrbewegung der Handhabungseinrichtung von letztgenannter erfassen lassen.

6. Speichervorrichtung nach einem oder mehreren der vorhergehenden Ansprüche, **gekennzeichnet dadurch, daß** die erste Handhabungseinrichtung (10) einen Stapelgreifer aufweist, der mit einer Anzahl an Greifern versehen ist, durch die sich ein vollständiger Stapel von Objekten aus einer Transportbox entnehmen lässt.

7. Speichervorrichtung nach Anspruch 6, **dadurch gekennzeichnet, dass** in den Speichermitteln (25) ein Abstand benachbarter Speicherstellen für Objekte geringer ist als ein Abstand benachbarter Greifer des Stapelgreifers (10).

8. Speichervorrichtung nach einem oder mehreren der vorhergehenden Ansprüche, **gekennzeichnet dadurch, daß** die Transfereinrichtung (20) einen Transfergreifer aufweist, mit dem im Be-/Entladebereich (4) des Innenraums aus einem in die Speichervorrichtung eingeführten Stapel jeweils zumindest ein Objekt erfasst und in ein an einem Ladeplatz (30) angeordneten Speichermittel (25) einsetzbar ist.

9. Speichervorrichtung nach einem oder mehreren der vorhergehenden Ansprüche, **gekennzeichnet durch** eine Detektionsstation, in der zumindest ein Objekt angeordnet werden kann, die Detektionsstation mit einem Drehmittel versehen ist, mit dem ein Objekt in Bezug auf eine parallel zu einer Oberfläche des Objektes verlaufende Achse um 180°drehbar ist.

10. Speichervorrichtung nach einem oder mehreren der vorhergehenden Ansprüche, **gekennzeichnet durch** eine Detektionsstation, in der zumindest ein Onjekt angeordnet werden kann und bei der Kontaktstellen für Objekte drehbar sind, wodurch das Objekt um eine orthogonal zu einer Oberfläche des Substrats drehbar ist.

11. Speichervorrichtung nach einem oder mehreren der vorhergehenden Ansprüche, **gekennzeichnet durch** zumindest ein Strömungsleitmittel, das einen Teilstrom eines Reinraumluftstromes so leitet, dass er nur wenige, jedoch höchstens vier, vorzugsweise im wesentlichen nur ein, Speichermittel durchströmt.

12. Verfahren zur Erstellung eines Substratstapels aus zumindest einem Ausgangsstapel von Substraten, bei dem Substrate in einer Transportbox (8) einer Speichervorrichtung (1) zugeführt werden, die Substrate in einen Innenraum eines Gehäuses (2) der Speichervorrichtung eingeführt und im Innenraum in Speichermitteln (25) als Ausgangsstapel zwischengelagert werden, mittels einer Transfereinrichtung (20) Substrate aus zumindest einem Speichermittel (25) entnommen und zu einem Substratstapel zusammengestellt werden, **dadurch gekennzeichnet, dass** die Substrate ohne die Transportbox (8) in den Innenraum eingeführt werden, dort die Substrate in das zumindest eine Speichermittel (25) angeordnet werden, das Speichermittel zu einer Zwischenlagerung an einem Lagerplatz (43) des Innenraums abgesetzt wird, und das zumindest eine Speichermittel (25) zusammen mit darin angeordneten Wafern von dem Lagerplatz (43) des jeweiligen Speichermittels (25) zu einem Ladeplatz (30) des Innenraums transportiert wird, an dem durch Entnahme von Substraten aus einem oder mehreren der Speichermittel (25) ein Substratstapel zusammenstellbar ist.

13. Verwendung einer Speichervorrichtung gemäss einem oder mehreren der vorhergehenden Ansprüche 1 bis 11, **dadurch gekennzeichnet, dass** in ihr Testwafer offen zwischengelagert werden.

## Claims

1. A storage device for an intermediate storage of objects provided for the production of semiconductor devices, said objects being objects such as substrates, wafers (15, 15a), in particular test wafers, and the like, wherein the storage device
has a housing (2) that encloses an inner chamber, a device being provided in a loading/unloading region in the inner chamber for introducing and removing the objects from or into the housing,
At least one closable opening (6) being provided on the housing (2), through which opening the objects can be introduced and removed, wherein a transport box for objects can be arranged on the at least one opening (6) with its opening side,
furthermore, a first piece of handling equipment (10) is provided by means of which the objects in the leading/unloading region can be removed from the transport box, wherein by means of the first piece of handling equipment (10) one or a plurality of objects can be directly grasped and introduced into the inner chamber,
the objects being insertable into one of a plurality transportable storage means (25), which are already arranged within the inner chamber, such as, for example, magazines, wherein
storage areas (43) are present for the storage means in the inner chamber, the storage means (25) being arrangeable in storage areas (43) of the inner chamber by means of a second piece of handling equipment (46), and the storage device furthermore
has a transfer device (20), which is provided in the inner chamber, for the formation of object stacks and, to assemble a stack of objects, one or a plurality of objects are removable from at least one storage means (25) and insertable into a receptacle arranged in the inner chamber.

2. The storage device as specified in claim 1, **characterised in that** individual storage means (25) respectively have a plurality of storage locations for respectively one object.

3. The storage device as specified in one or both of the preceding claims, **characterised in that** the storage means (25) have storage locations for wafers (15, 15a) in which the wafers (15, 15a) can be arranged on the storage areas in a direction that is substantially vertical.

4. The storage device as specified in one or more of the preceding claims, **characterised in that** the storage means (25) are configured in the form of cartridges in which slits create storage locations for wafers (15, 15a).

5. The storage device as specified in one or more of the preceding claims, **characterised in that** the storage means (25) has elements with which, upon the displacement movement of the handling equipment, it is possible to detect such of said handling equipment.

6. The storage device as specified in one or more of the preceding claims, **characterised in that** the first piece of handling equipment (10) has a stack grasper that is provided with a number of grippers by means of which a complete stack of objects can be removed from a transport box.

7. The storage device as specified in claim 6, **characterised in that** in the storage means (25), a distance between adjacent storage locations for objects is less than a distance between adjacent grippers of the stack grasper (10)

8. The storage device as specified in one or more of the preceding claims, **characterised in that** the transfer device (20) has a transfer gripper with which, in the loading/unloading region (4) of the inner chamber, it can grasp respectively at least one object in the storage device into which it has been inserted and introduce it into a storage means (25) arranged on a loading bay (30).

9. The storage device as specified in one or more of the preceding claims, **characterised by** a detection station in which at least one object can be arranged, the detection station being provided with a rotary means with which an object is rotatable 180° with respect to an axis running parallel to a surface of the object.

10. The storage device as specified in one or more of the preceding claims, **characterised by** a detection station in which at least one object can be arranged and with which contact locations for objects are rotatable, by means of which the object is rotatable about an orthogonal to a surface of the substrate.

11. The storage device as specified in one or more of the preceding claims, **characterised by** at least one flow conduction means that conducts a partial flow of a clean room air flow in such a manner that it flows through only few, however maximally four, preferably substantially only one, storage means.

12. A method for creating a substrate stack from at least one output stack of substrates, in which substrates are supplied in a transport box (8) of a storage device (1), the substrates being introduced into an inner chamber of the housing (2) of the storage device and subsequently being intermediately stored in storage means (25) as an output stack, substrates being removed from at least one storage means (25) and assembled into a substrate stack by means of a transfer device (20), **characterised in that** the substrates are introduced into the inner chamber without the transport box (8), in which inner chamber the substrates are arranged in the at least one storage means (25), said storage means being moved to an intermediate storage in a storage area (43) of the inner chamber, and the at least one storage means (25) being transported together with wafers arranged therein from the storage area (43) of the respective storage means (25) to a loading bay (30) of the inner chamber on which a substrate stack can be assembled by the removal of substrates from one or a plurality of the storage means (25).

13. A use of a storage device according to one or more of the previous claims 1 to 11, **characterised in that** test wafers can be openly intermediately stored therein.

## Revendications

1. Dispositif de stockage à des fins de stockage intermédiaire d'objets prévus pour la production de composants semi-conducteurs, comme des substrats, des tranches (15,15a), notamment des tranches de test, et similaire, dans lequel le dispositif de stockage
présente un logement (1), qui définit un espace intérieur, dans lequel espace intérieur dans une zone de chargement/déchargement un dispositif est prévu pour faire rentrer et sortir l'objet dans, resp. hors du logement, à quelle fin
sur le logement (2) au moins une ouverture (6) refermable est prévue, à travers laquelle les objets peuvent être rentrés et sortis, dans lequel sur la au moins une ouverture (6) une boîte de transport d'objets peut être disposée par son côté d'ouverture,
en outre un premier dispositif de manipulation (10) est prévu, au moyen duquel les objets dans la zone de chargement/déchargement peuvent être retirés de la boîte de transport, dans lequel au moyen du premier dispositif de manipulation (10), un ou plusieurs objets sont directement saisis et introduits dans l'espace intérieur,
les objets peuvent être placés dans un de plusieurs moyens de stockage (25) ouverts transportables, déjà disposés à l'intérieur de l'espace intérieur, comme par exemple des magasins, dans lequel dans l'espace intérieur destiné aux moyens de stockage des emplacements de stockage (43) sont présents, les moyens de stockage (25) peuvent être disposés au moyen d'un deuxième dispositif de manipulation (46) dans des emplacements de stockage (43) de l'espace intérieur, et le dispositif de stockage en outre
présente un dispositif de transfert (20) prévu dans l'espace intérieur pour former des piles d'objets, avec lequel afin de composer une pile d'objets constituée d'au moins un moyen de stockage (25), un ou plusieurs objets peuvent être retirés et placés dans un réceptacle disposé dans l'espace intérieur.

2. Dispositif de stockage selon la revendication 1, **caractérisé en ce que** un moyen de stockage (25) individuel présente respectivement plusieurs places de stockage pour respectivement un objet.

3. Dispositif de stockage selon une ou les deux des revendications précédentes, **caractérisé en ce que** les moyens de stockage (25) présentent des places de stockage des tranches (15,15a), dans lesquelles les tranches (15,15a) peuvent être disposées sur leurs emplacements de stockage dans une orientation essentiellement verticale.

4. Dispositif de stockage selon une ou plusieurs des revendications précédentes, **caractérisé en ce que** des moyens de stockage (25) sont réalisés sous forme de cassettes, dans lesquelles des fentes réalisent des places de stockage des tranches (15,15a).

5. Dispositif de stockage selon une ou plusieurs des revendications précédentes, **caractérisé en ce que** les moyens de stockage (25) présentent des éléments, avec lesquels ils peuvent être saisis lors d'un mouvement de déplacement du dispositif de manipulation par ce dernier.

6. Dispositif de stockage selon une ou plusieurs des revendications précédentes, **caractérisé en ce que** le premier dispositif de manipulation (10) présente un organe de préhension de pile, qui est pourvu d'une pluralité de pinces de préhension, par l'intermédiaire desquelles une pile complète d'objets peut être retirée d'une boîte de transport.

7. Dispositif de stockage selon la revendication 6, **caractérisé en ce que** dans les moyens de stockage (25), un espacement de places de stockage pour objets voisins est plus petit qu'un espacement de prince de préhension voisine de l'organe de préhension de pile (10).

8. Dispositif de stockage selon une ou plusieurs des revendications précédentes, **caractérisé en ce que** le dispositif de transfert (20) présente un organe de préhension de transfert, avec lequel dans la zone de chargement/déchargement (4) de l'espace intérieur au moins un objet est saisi hors d'une pile introduite dans le dispositif de stockage et peut être placé dans un moyen de stockage (25) disposé sur une place de chargement (30).

9. Dispositif de stockage selon une ou plusieurs des revendications précédentes, **caractérisé par** un poste de détection, dans lequel au moins un objet peut être disposé, le poste de détection est pourvu d'un moyen rotatif, avec lequel un objet peut être tourné à 180° par rapport à un axe s'étendant parallèlement à une surface de l'objet.

10. Dispositif de stockage selon une ou plusieurs des revendications précédentes, **caractérisé par** un poste de détection, dans lequel au moins un objet peut être disposé et sur lequel des emplacements de contact des objets sont rotatifs, moyennant quoi l'objet peut être tourné autour d'un axe orthogonal par rapport à une surface du substrat.

11. Dispositif de stockage selon une ou plusieurs des revendications précédentes, **caractérisé par** au moins un moyen de guidage d'écoulement, qui guide un courant partiel d'un courant d'air de chambre stérile de telle sorte qu'il traverse seulement peu, néanmoins au plus quatre, de préférence essentiellement un, moyens de stockage.

12. Procédé de réalisation d'une pile de substrats à partir d'au moins une pile de départ de substrats, dans lequel des substrats sont introduits dans une boîte de transport (8) d'un dispositif de stockage (1), les substrats sont guidés dans un espace intérieur d'un logement (2) du dispositif de stockage et sont stockés de manière intermédiaire dans l'espace intérieur dans des moyens de stockage (25) en tant que pile de départ, au moyen d'un dispositif de transfert (20) des substrats sont retirés d'au moins un moyen de stockage (25) et sont rassemblés en une pile de substrats, **caractérisé en ce que** les substrats sont guidés sans la boîte de transport (8) dans l'espace intérieur, à cet endroit les substrats sont disposés dans au moins un moyen de stockage, le moyen de stockage est déposé en un stockage intermédiaire sur un emplacement de stockage (43) de l'espace intérieur et au moins un moyen de stockage (25) ainsi que les tranches qui y sont disposées est transporté de l'emplacement de stockage (43) du moyen de stockage (25) respectif vers un emplacement de chargement (30) de l'espace intérieur, auquel en retirant les substrats hors d'un ou plusieurs des moyens de stockage (25) une pile de substrats peut être composée.

13. Utilisation d'un dispositif de stockage selon une ou plusieurs des revendications précédentes 1 à 11, **caractérisé en ce que** des tranches sont stockées de manière intermédiaire et ouverte dans celui-ci.
